# EUROPEAN PATENT APPLICATION

(11) **EP 0 973 192 A2**
(43) Date of publication of application: **19.01.2000**
(21) Application number: 99305444.4
(22) Date of filing: 08.07.1999
(51) Int. Cl.: H01L 21/48

(54) **Method and apparatus for processing resin sealed lead frame**

(30) Priority: 17.07.1998 JP 21961398; 20.11.1998 JP 33111798
(71) Applicant: Towa Corporation, Kyoto (JP)
(72) Inventor: Osada, Michio, Towa Corporation, Kyoto-shi, Kyoto (JP); Hidaka, Tetsuo, Towa Corporation, Utji-shi, Kyoto (JP); Horiuchi, Kazuo, Towa Corporation, Utji-shi, Kyoto (JP)
(74) Representative: Morton, Colin David

(57) **Abstract**

For processing a resin sealed lead frame according to the present invention, processing means (101, 102, 103, 104) related to a plurality of steps used for processing a lead of resin sealed lead frame (A) are separated as modules and detachably connected. Only the processing means as the modules related to the steps actually required for lead processing of the resin sealed lead frame are selected and connected. The resin sealed lead frame is sequentially fed to the processing means as the modules for lead processing of the resin sealed lead frame. Thus, a method of processing the resin sealed lead frame and an apparatus therefor which are capable of coping with a change in the type of the operation and the production volume are provided for lead processing of the resin sealed lead frame.

## Description

### BACKGROUND OF THE INVENTION

### Field of the Invention

The present invention relates to methods of processing a lead frame in which an electronic part such as an IC (an Integrated Circuit) is sealed with resin (hereinafter simply referred to as a resin sealed lead frame) and apparatuses therefor. More specifically, the present invention relates to a method of processing a resin sealed lead frame for cutting a prescribed portion of the resin sealed lead frame or separating each work (each electronic part forming a product) on the resin sealed lead frame and an improvement of the apparatus therefor.

### Description of the Background Art

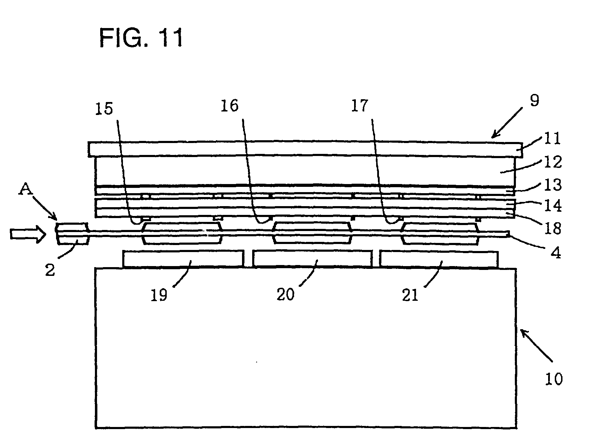

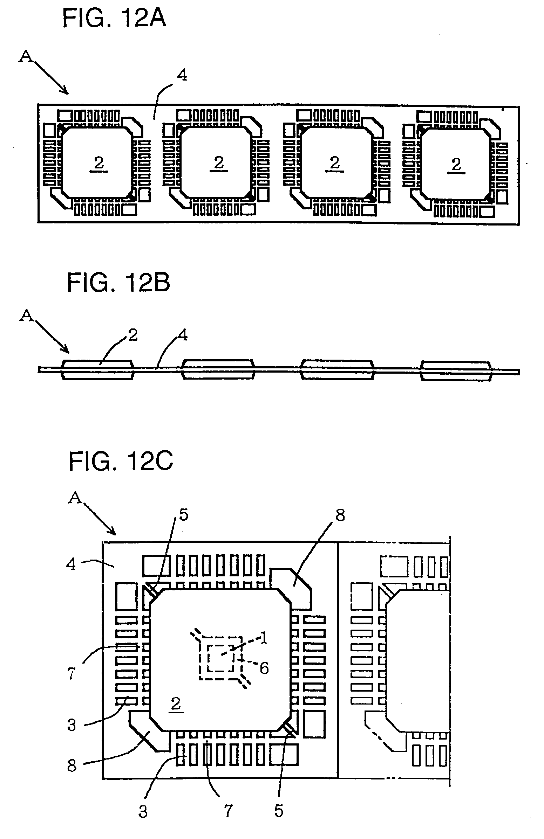

A first conventional art related to the present invention will now be described with reference to Figs. 11 and 12A to 12C. Fig. 11 generally shows a processing apparatus for a resin sealed lead frame according to the first conventional art. Figs. 12A to 12C schematically show an arrangement of a so-called QFP (Quad Flat Package) type resin sealed lead frame A in which outer leads 3 protrude from four sides of a resin sealed mold (a mold package) 2 in which an electronic part 1 is sealed.

In resin sealed lead frame A shown in Figs. 12A to 12C, a lead frame body 4 and a die pad 6 for mounting electronic part 1 are connected by a pinch lead 5. A dam bar 7 is provided for preventing a melt resin material from flowing out of a mold cavity at the time of sealing electronic part 1 with resin. A cavity flow 8 which serves as a resin pool is further arranged. Four electronic parts 1 are mounted to lead frame body 4, each electrically connected to a prescribed outer lead.

For cutting and separating each work from resin sealed lead frame A, for examples various cutting steps, such as cutting of cavity flow 8, cutting of the resin at dam bar 7, cutting of dam bar 7, cutting of a tip connecting portion of outer lead 3 and cutting of pinch lead 5, must be performed.

A plurality of such cutting steps, for example, the above mentioned resin cutting step and the dam bar cutting step can be performed almost simultaneously, depending on a thickness, shape or the like of lead frame body 4. At the same time, any unnecessary step may be eliminated. The above mentioned separation of each work is performed by a lead processing apparatus having an upper mold 9 and a lower mold 10, for example as shown in Fig. 11.

The lead processing apparatus illustrated in Fig. 11 is structured to perform only the above mentioned cavity flow cutting step, dam bar cutting step and pinch lead cutting step. More specifically, the lead processing apparatus shown in Fig. 11 is provided with a structure of a so-called sequentially feeding mold and includes: an upper mold base 11; a punch holder 12 fixed to upper mold base 11; a punch blade 13 fixed to punch holder 12; a stripper blade 14 suspended from punch blade 13, cavity flow cut punch 15 for cutting cavity flow 8; a dam bar cut punch 16 for cutting the resin at dam bar 7; and a pinch lead cut punch 17 for cutting pinch lead 5.

Base portions of punches 15, 16 and 17 are fixed to the same punch holder 12 through punch blade 13, and their tip blades are fitted onto a punch guide 18. Dies 19, 20 and 21 are arranged on lower mold 10, respectively corresponding to punches 15, 16 and 17.

As shown in Fig. 11, resin sealed lead frame A is fed to a prescribed position between upper and lower molds 9 and 10, and the cutting steps are sequentially performed by punches 15, 16, 17 and dies 19, 20, 21 while sequentially feeding each work on resin sealed lead frame A. Thus, each work is sequentially separated.

As described above, in the conventional lead processing apparatus, each punch used for cutting and separating the work on resin sealed lead frame A is integrally fixed to one mold base, and the die corresponding to the punch is integrally fixed to the other mold base.

When lead processing is to be performed for a different type of resin sealed lead frame, the above described lead processing apparatus cannot be directly used. Then, a different lead processing apparatus for the resin sealed lead frame must be prepared, or any unnecessary punches and dies fixed to the mold base are removed so that different punches and the dies required for the lead processing are integrally fixed to the mold base.

Preparation of a dedicated lead processing apparatus for every kind of resin sealed lead frame is extremely uneconomical, and changing of the punches and dies for every kind of resin sealed lead frame requires not only laborious operation but also skill in fine adjusting after the change.

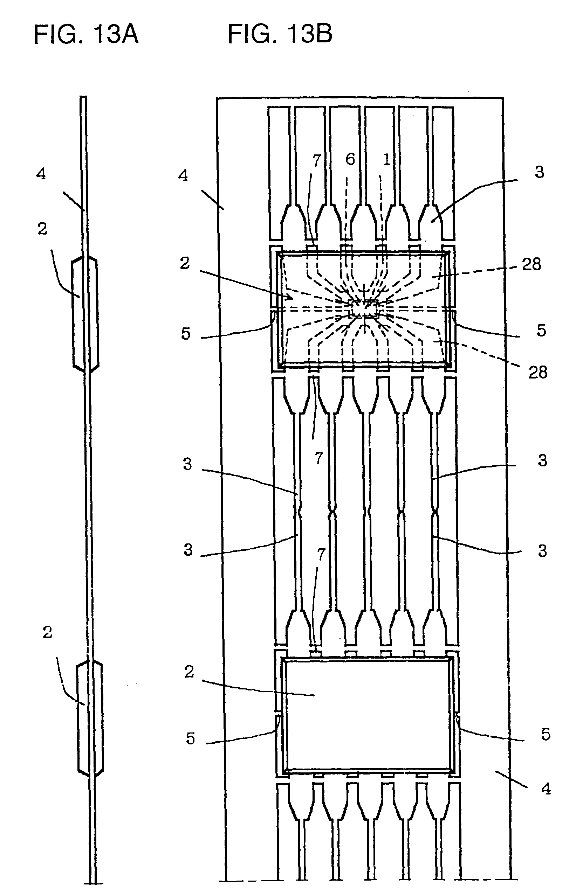

A second conventional art related to the present invention will be described with reference to Figs. 13A and 13B. It is noted that elements corresponding to those of the above described first conventional art shown in Figs. 12A to 12C are denoted by the same reference numerals. Figs. 13A and 13B schematically show an exemplary arrangement of a resin sealed lead frame in which outer leads 3 protrude from two sides of a resin sealed mold 2 including an electronic part 1.

In the resin sealed lead frame according to the second conventional art shown in Figs. 13A and 13B, a cradle 4 and a die pad 6 for mounting electronic part 1 are connected by a pinch lead 5. A dam bar 7 is further provided to prevent melt resin from flowing out of a mold cavity at the time of sealing electronic part 1 with resin. A prescribed number of electronic parts 1 are mounted on cradle 4, each electrically connected to a prescribed inner lead 28.

For the step of separating each work from the resin sealed lead frame, a lead processing apparatus having a so-called sequentially feeding mold is used. The mold includes a punch and die for cutting and thereby performs each cutting step while sequentially feeding the resin sealed lead frame to a prescribed position between the punch and die. For example, the mold sequentially performs cutting of resin (removal of resin) at dam bar 7, cutting of dam bar 7, cutting of a tip connecting portion of an outer lead 3, cutting of pinch lead 5 or the like.

It is noted that if a mold for bending outer lead 3 is provided along with the above described mold for cutting, a step of bending the outer lead can be simultaneously or separately performed. However, as the bending of the lead is performed in a manner substantially similar to that of the above mentioned cutting steps, the description thereof is not given here.

In the conventional method of processing the lead described with reference to Figs. 13A and 13B, while sequentially feeding the works on the lead frame by a distance equal to a pitch between the works (hereinafter referred to as one pitch) along a feeding path, the works are pressed by molds for cutting which are spaced by one pitch on the feeding path. In the final processing step, each work is sequentially cut and separated from the resin sealed lead frame to produce separate products. To increase a production volume in the same period of time, the number of lead processing apparatuses having similar functions and structures must be provided. For example, to double the production volume in the same period of time, two lead processing apparatuses having similar structures must be provided. In this case, twice as much equipment cost and space are required.

### SUMMARY OF THE INVENTION

An object of the present invention is to provide a method of processing a resin sealed lead frame capable of simply coping with a change in the processing operation and a change in the production volume for processing the resin sealed lead frame and an apparatus therefor.

According to one aspect, the method of processing the resin sealed lead frame according to the present invention which achieves the above described object is characterized in that each of processing means corresponding to a plurality of steps for processing the lead of the resin sealed lead frame are separated as modules and detachably connected, only the processing means as the modules required for processing the lead of the resin sealed lead frame are selected and mutually connected, and the lead of the resin sealed lead frame is processed.

A processing apparatus for the resin sealed lead frame according to the present invention to perform the above described method of processing according to the first aspect is characterized in that the processing means corresponding to the plurality of steps for processing the lead of the resin sealed lead frame are separated as modules and detachably connected.

According to the present invention, as the processing means for the steps required for processing the lead of the resin sealed lead frame are separated as the detachable modules, the lead processing apparatus for the resin sealed lead frame including the processing means for the desired steps can be simply and promptly structured by suitably connecting or disconnecting the modules as necessary.

Therefore, a dedicated lead processing apparatus needs not be prepared for every kind of the resin sealed lead frame, and the operation of changing punches and dies, fine adjusting operation after the change or the like can be eliminated. As a result, the apparatus can simply cope with a change in the processing operation for processing the lead of the resin sealed lead frame, whereby productivity of various products considerably increases.

According to the present invention, the dedicated lead processing apparatus needs not be prepared for every kind of the resin sealed lead frame, so that an economic advantage is ensured. The number of modules can be increased or decreased depending on the actual lead processing operation, the other operation conditions or the like. In addition, the processing means for the unnecessary steps can be eliminated from the lead processing apparatus, so that an overall reduction in the equipment cost can effectively be achieved.

According to another aspect, a method of processing a resin sealed lead frame according to the present invention relates to a processing method using a processing apparatus for the resin sealed lead frame including: a feeding portion for the resin sealed lead frame before lead processing provided along a feeding path of the resin sealed lead frame; a lead processing portion for the resin sealed lead frame connected to the feeding portion; and a removing portion for the resin sealed lead frame after the lead processing which is detachably connected to the lead processing portion. In the processing method, the resin sealed lead frame is sequentially fed by a plurality of pitches (at least two pitches) when a pitch between the works on the resin sealed lead frame corresponds to one pitch with a plurality of lead processing basic units having the same lead processing function detachably connected in series in the lead processing portion. A prescribed lead processing is performed for the works by the plurality of lead processing basic units in the lead processing portion at prescribed positions spaced by a plurality of pitches of the resin sealed lead frame. Subsequently, the resin sealed lead frame is removed from the removing portion.

In a method of processing the resin sealed lead frame, a step of cutting and separating the works on the resin sealed lead frame can be further provided before removal of the resin sealed lead frame from the removing portion.

The processing apparatus for the resin sealed lead frame of the present invention to perform the above described processing method according to the second aspect includes: a feeding portion (30) for the resin sealed lead frame before lead processing which is provided along a feeding path of the resin sealed lead frame; a lead processing portion for the resin sealed lead frame detachably connected to the feeding portion; and a removing portion for the resin sealed lead frame after the lead processing which is detachably connected to the lead processing portion. The lead processing portion includes a plurality of lead processing basic units which have the same lead processing function and are detachably connected in series.

In the processing method and processing apparatus of the present invention according to the above described second aspect, the lead processing portion and removing portion are detachably connected. A plurality of lead processing basic units having the same lead processing function and detachably connected in series are provided in the lead processing portion. Thus, the present invention can effectively provide the processing method and apparatus for the resin sealed lead frame capable of simply and promptly cope with a change in the production volume.

A lead processing apparatus provided with one lead processing basic unit as the lead processing portion or a plurality of (two or more) lead processing basic units can be arbitrarily selected and employed. When the structure including at least two lead processing units as the lead processing portions is selected and employed, the production volume can be increased multiple times, corresponding to the number of the lead processing basic units.

Further, when at least two lead processing basic units are provided as the lead processing portions, the feeding portion for the resin sealed lead frame before lead processing and the removing portion for the resin sealed lead frame after lead processing may be the same. Therefore, as compared with the case where at least two lead processing apparatuses having full functions and structures are separately provided, an overall reduction in the overall equipment cost and space for the lead processing apparatus can be achieved.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic front view generally showing a processing apparatus for a resin sealed lead frame according to a first embodiment of the present invention.

Figs. 2A to 2D are schematic front views showing modules of the processing apparatus for the resin sealed lead frame shown in Fig. 1, respectively corresponding to a cavity flow cut, resin cut, dam bar cut and pinch lead cut modules.

Fig. 3 is a schematic front view generally showing a structure of a cavity flow cut module according to a second embodiment of the present invention.

Fig. 4 is a schematic front view generally showing a processing apparatus for the resin sealed lead frame according to the second embodiment of the present invention, where the cavity flow cut module corresponding to Fig. 3 is connected to the other module.

Figs. 5A and 5B are schematic diagrams generally showing a processing apparatus for a resin sealed lead frame according to a third embodiment of the present invention, where Fig. 5A shows a basic structure thereof and Fig. 5B shows another lead processing portion having the same function added to the basic structure shown in Fig. 5A.

Fig. 6A is a front view schematically showing in enlargement a main portion of a lead processing portion of the lead processing apparatus shown in Figs. 5A and 5B, and Fig. 6B is a plan view schematically showing in enlargement a main portion of the resin sealed lead frame of the apparatus.

Figs. 7A and 7B are diagrams shown in conjunction with a step and function for the basic structure of the lead processing apparatus corresponding to Fig. 5A.

Figs. 8A and 8B are diagrams shown in conjunction with a step and function for a structure of the lead processing apparatus in Fig. 5B to which another lead processing portion is added.

Fig. 9A is a schematic diagram generally showing a lead processing apparatus according to a fourth embodiment of the present invention, and Fig. 9B is a diagram shown in conjunction with the step and function thereof.

Fig. 10A is a schematic diagram generally showing a lead processing apparatus according to a fifth embodiment of the present invention, and Fig. 10B is a diagram shown in conjunction with the step and function thereof.

Fig. 11 is a front view generally showing an overall structure of a processing apparatus for a resin sealed lead frame according to the first conventional art.

Fig. 12A is a plan view schematically showing the resin sealed lead frame according to the first conventional art, and Fig. 12B is a front view schematically showing the same, and Fig. 12C is a plan view schematically showing in enlargement a part of the same.

Fig. 13A is a front view schematically showing a resin sealed lead frame according to the second conventional art, and Fig. 13B is a plan view schematically showing the same.

### DESCRIPTION OF THE PREFERRED EMBODIMENTS

### First Embodiment

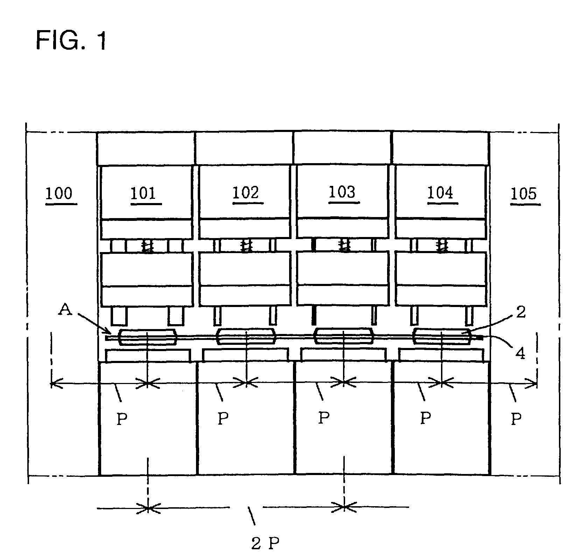

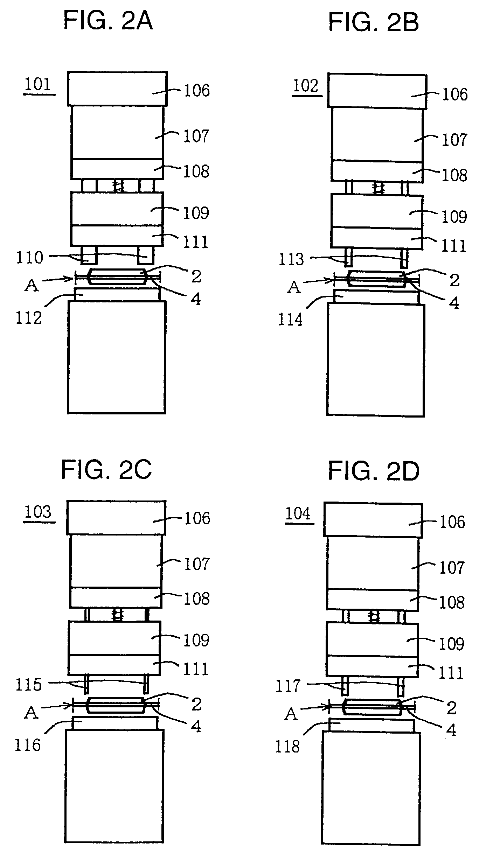

Now, a first embodiment of the present invention will be described in detail with reference to Figs. 1 and 2A to 2D.

Referring to Fig. 1, a processing apparatus for a resin sealed lead frame according to the present embodiment, the processing means for a plurality of steps required for processing the lead of the resin sealed lead frame are separately provided as modules. The separate modules are detachable and can suitably be connected or disconnected as necessary. Thus, a structure of the processing apparatus provided with a desired lead processing portion can be employed.

More specifically, the above described processing apparatus includes: a feeding portion (a feeding module for the resin sealed lead frame) 100 for a resin sealed lead frame A; a cavity flow cut module 101 connected to feeding portion 100; a resin cut module 102 connected to cavity flow cut module 101; a dam bar cut module 103 connected to resin cut module 102; a pinch lead cut module 104 connected to dam bar cut module 103; and a receiving portion (a module for receiving a work) 105 connected to pinch lead cut module 104, which modules are all integrally connected in series.

Each of feeding portion 100, modules 101 to 104 and receiving portion 105 are detachable.

Pitches P between any two of feeding portion 100, modules 101 to 104 and receiving portion 105 which are integrally connected in series are all equal. Thus, modules 101 to 104 are provided to form the processing apparatus including only processing means necessary for desired steps by selecting only necessary modules and suitably connecting or disconnecting the same depending on a thickness, shape or the like of a lead frame body 4.

As modules 101 to 104 can be suitably combined depending on the actual operation for processing the lead of the resin sealed lead frame, the other operation conditions or the like, the apparatus is advantageously adjusted for the specific operation. In addition, any processing means for the unnecessary step can be removed from the apparatus, so that a reduction in the overall equipment cost can be achieved.

It is noted that the cutting process for the resin sealed lead frame A is extremely difficult when pitches P for the works on resin sealed lead frame A and hence pitches P for modules 101 to 104 are narrow. Then, as indicated by a reference character 2P in Fig. 1, the above described pitch P may be, for example, doubled to have two pitches. In this case, resin sealed lead frame A may be sequentially fed by two pitches and the cutting process for resin sealed lead frame A may be performed by each module corresponding the sequentially fed position.

Provided in the above described feeding portion 100 for resin sealed lead frame A is a set portion of a magazine including a plurality of resin sealed lead frames A. The magazine including resin sealed lead frame A is transported to a prescribed position in cavity flow cut module 101 connected to feeding portion 100 by a suitable transporting mechanism such as an engageable chuck (not shown).

Referring to Fig. 2A, cavity flow cut module 101 includes: an upper mold base 102 ; a punch holder 107 fixed to upper mold base 106; punch blade 108 fixed to punch holder 107; a stripper blade 109 suspended from punch blade 108; a cavity flow cut punch 110 for cutting cavity flow 8 of the resin sealed lead frame; a punch guide 111 for mounting a tip blade of punch 110; and a die 112 positioned on the side of the lower mold corresponding to punch 110.

Cavity flow cut punches 110 are arranged corresponding to the number and positions of cavity flows 8 in each work on resin sealed lead frame A. For example, two cavity flows 8 are formed in one work on resin sealed lead frame A shown in Figs. 12A to 12C, so that two cavity flow punches 110 are provided in total.

Thus, cavity flows 8 for resin sealed lead frame A which have been transported to a prescribed position in cavity flow cut module 101 by the above described transporting mechanism are simultaneously cut (punched) by cavity flow cut punch 110 and die 112 at the time of clamping of the upper and lower molds.

Resin sealed lead frame A which has been subjected to the cavity flow cut step is transported to a prescribed position in resin cut module 102 connected to cavity flow cut module 101 by the above mentioned transporting mechanism.

Referring to Fig. 2B, resin cut module 102 is provided with substantially the same structure as that of cavity flow cut module 101 except for resin cut punch 113 die 114 for cutting the resin at dam bar 7 of resin sealed lead frame A. Therefore, the elements which are substantially the same as those of cavity flow cut module 101 are denoted by the same reference numerals in Fig. 2B.

The resin at dams in resin sealed lead frame A which has been transported to a prescribed position in resin cut module 102 by the above mentioned transporting mechanism are simultaneously cut by resin cut punch 113 and die 114 at the time of clamping of the upper and lower molds.

Resin sealed lead frame A after the resin cut step is transported to a prescribed position in dam bar cut module 103 connected to resin cut module 102 by the transporting mechanism.

Referring to Fig. 2C, dam bar cut module 103 has a structure which is substantially the same as that of the above described each module except for a dam bar cut punch 115 and die 116 for cutting dam bar 7 of resin sealed lead frame A. Therefore, the elements which are substantially the same as those of the above described each module are denoted by the same refercnce numerals also in Fig. 2C.

Dam bars 7 of resin sealed lead frame A which has been transported to a prescribed position in dam bar cut module 103 by the transporting mechanism are simultaneously cut by dam bar cut punch 115 and die 116 at the time of clamping of the upper and lower molds.

Resin sealed lead frame A after the dam bar cut step is transported to a prescribed position in pinch lead cut module 104 connected to dam bar cut module 103 by the above mentioned transporting mechanism.

Referring to Fig. 2D, pinch lead cut module 104 has a structure which is substantially the same as that of the above described each module except for a pinch lead cut punch 117 and a die 118 for cutting pinch lead 5 in resin sealed lead frame A. Therefore, the elements which are substantially the same as those of the above described each module are denoted by the same reference numerals also in Fig. 2D.

Pinch leads 5 of resin sealed lead frame A which has been transported to a prescribed position in pinch lead cut module 104 by the above mentioned transporting mechanism are simultaneously cut by pinch lead cut punch 117 and die 118 at the time of clamping of the upper and lower molds.

Each work which has been cut and separated from resin sealed lead frame A by the above described pinch lead cut step is transported to a receiving portion (a receiving module for each work) 105 connected to pinch lead cut module 104.

To separate each work from resin sealed lead frame A using the above described lead processing apparatus, as described above, resin sealed lead frame A is sequentially fed to a prescribed position between the upper and lower molds in each of modules 101 to 104 from feeding portion 100 by the transporting mechanism for sequentially performing the cutting steps by punches 110, 113, 115, 117 and dies 112, 114, 116, 118. As described above, the separated work may be transported toward receiving portion 105 by the transporting mechanism.

It is noted that as pitches P for feeding portion 100, modules 101 to 104 and receiving portion 105 which are integrally connected in series are all equal, a process similar to that described above can be performed for a resin sealed lead frame having the equal pitch P.

When any of steps for modules 101 to 104 is not necessary depending on the state of the actual operation for processing the lead of the resin sealed lead frame, and the other operation conditions or the like, the module related to the unnecessary step may be removed. Conversely, if any additional processing step is required, a module related to the step may be added to the apparatus.

### Second Embodiment

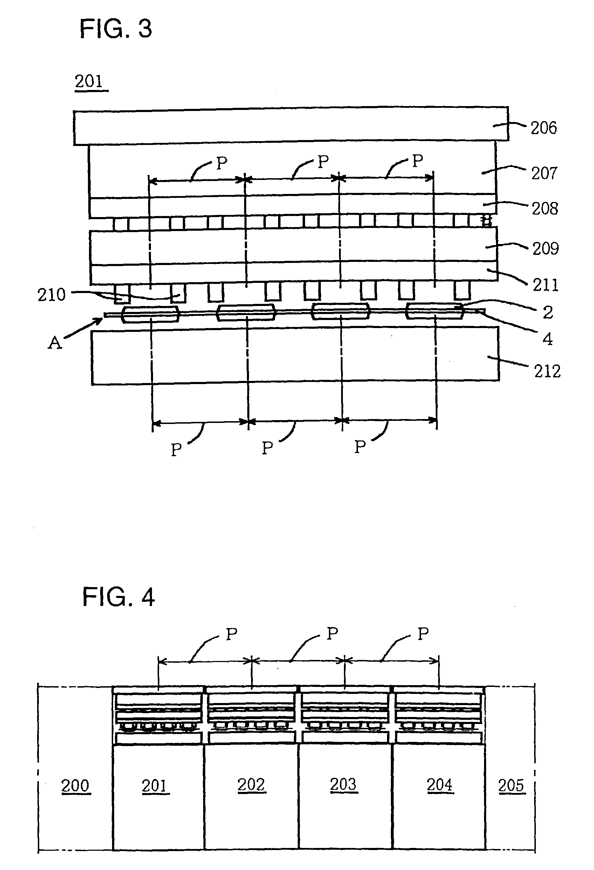

Now, a second embodiment of the present invention will be described with reference to Figs. 3 and 4.

In the above described first embodiment, one work on resin sealed lead frame A is sequentially processed by each of modules 101 to 104. In the second embodiment, a plurality of works on the resin sealed lead frame are simultaneously processed by each of the modules. For example, in Fig. 3, resin sealed lead frame A has four works. Fig. 3 also shows an exemplary structure of cavity flow cut module 201 for simultaneously cutting cavity flows of four works.

More specifically, the structure of cavity flow cut module 201 is substantially the same as that of cavity flow cut module 101 according to the first embodiment except that cavity flow cut punch 210 and die 212 are provided for cutting the cavity flows of four works. In the present embodiment, an upper mold base 206, a punch holder 207, a punch blade 208, a stripper blade 209 and a punch guide 211 are also provided.

As in cavity flow cut module 201, a punch and die for processing the above described four works can be provided in each of the modules other than cavity flow cut module 201.

Pitch P between cavity flow cut punch 210 and die 212 arranged in cavity flow cut module 201 and pitch P for the works of resin sealed lead frame A are all equal. In the second embodiment shown in Figs. 3 and 4, as in the case of the first embodiment shown in Figs. 1 and 2, the modules are detachable and can be suitably connected or disconnected as necessary as shown in Fig. 4, so that a processing apparatus provided with processing means related to desired steps is obtained.

As in the above described first embodiment, the second embodiment shown in Figs. 3 and 4 also includes a feeding portion 200 for resin sealed lead frame A, cavity flow cut module 201, resin cut module 202, dam bar cut module 203, pinch lead cut module 204 and receiving portion 205 for each work.

To cut and separate each work from resin sealed lead frame A using the lead processing apparatus according to the present embodiment, resin sealed lead frame A is transported from feeding portion 101 to cavity flow cut module 201 by a suitably provided transporting mechanism, for simultaneously cutting cavity flows of four works.

As in the cavity flow cut step, resin sealed lead frame A is sequentially transported to a prescribed position between the upper and lower molds in each of modules 202 to 204 connected to cavity flow cut module 201 for simultaneously performing the cutting step by the punch and die for the above mentioned four works.

As described above, each of the separated works needs only be transported to receiving portion 205 for each work by the transporting mechanism.

It is noted that pitch P between the punch and the die in each of modules 201 to 204 and pitch P for the works of resin sealed lead frame A are equal, and the step of transporting resin sealed lead frame A to each of modules 201 to 204 can be accurately and surely performed by the transporting mechanism, so that pitches P for modules 201 to 204 shown in Fig. 4 needs not be completely equal.

In the above described each of the embodiments, only the step of cutting and separating each work from the resin sealed lead frame is described as the step required for processing the lead. However, a so-called forming step for bending and forming an outer lead of each work in a prescribed shape may be included as a step required for processing the lead.

Thus, as in the case of each of modules 101 to 104 and 201 to 204, the processing means related to the step required for forming is separately provided as a module and detachably connected to pinch lead cut module 104, 204 or the like, which corresponds to the final step. The work which has been cut and separated after the final step is transported to a forming module by a suitably provided transporting mechanism. In this case, not only the step of cutting and separating each work from the resin sealed lead frame is performed, but also lead forming of each work can be automatically performed sequentially after the cutting step, so that a more practical advantage is obtained.

### Third Embodiment

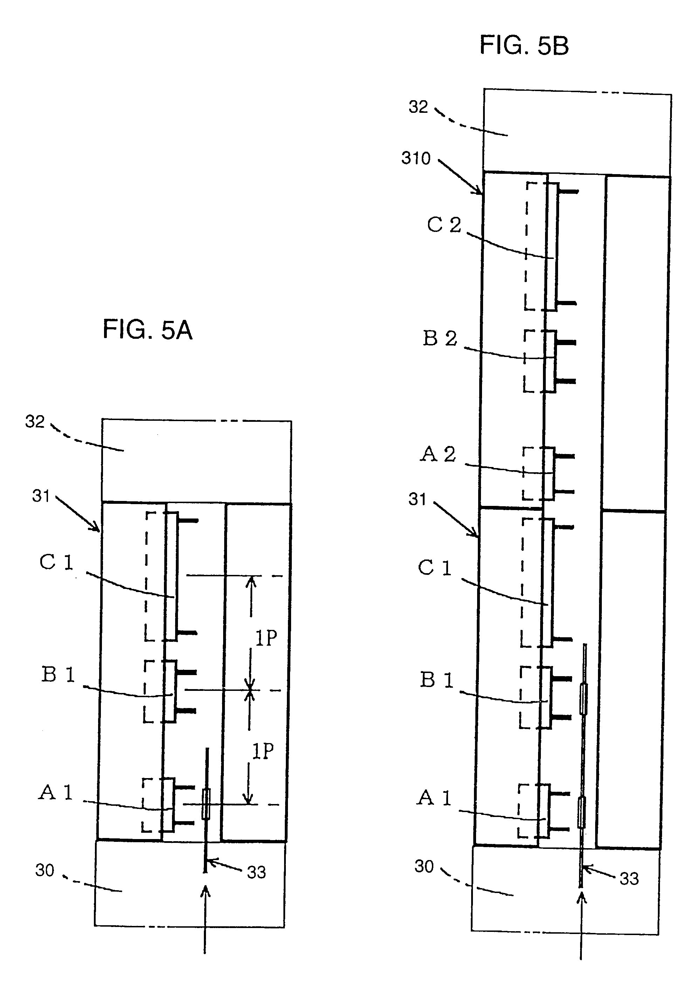

A third embodiment of the present invention will now be described in detail with reference to Figs. 5A to 8B.

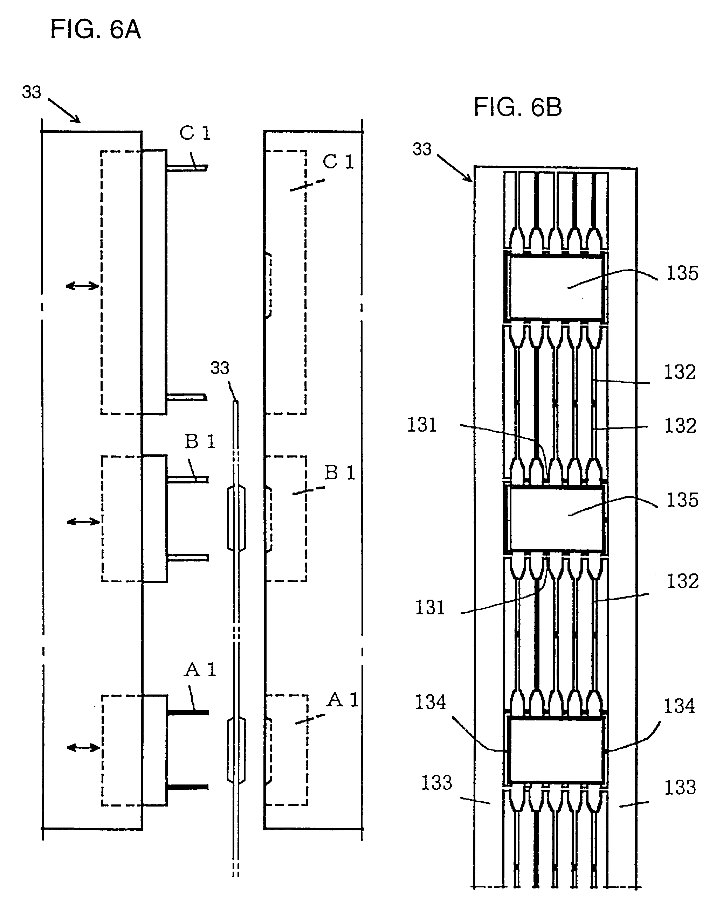

Referring to Figs. 5A and 6A, a processing apparatus according to the present embodiment includes as a basic structure thereof: a feeding portion 30 for a resin sealed lead frame before lead processing; one lead processing basic unit 31 connected to feeding portion 30 as a lead processing portion for the resin sealed lead frame; and a removing portion 32 for the resin sealed lead frame connected to lead processing basic unit 31 after lead processing.

It is noted that feeding portion 30 in the above described basic structure sequentially feeds resin sealed lead frame 33 along a feeding path by one pitch by a suitably provided feeding mechanism (not shown).

Lead processing basic unit 31 is provided with a mold including a required punch and die for cutting spaced by a distance (one pitch) equal to a pitch between the works on resin sealed lead frame 33.

In the illustrated exemplary structure, provided along the feeding path of the lead frame are: punch the die for resin cut A1 for cutting resin at dam bar 131 of resin sealed lead frame 33 as shown in Fig. 6B; punch and die for dam bar cut B1 for cutting dam bar 131; and punch and die for lead cut C1 for cutting a tip connecting portion of an outer lead 132.

Referring to Fig. 6B, the resin sealed lead frame according to the present invention includes: a cradle 133; a pinch lead 134 connecting cradle 133 and a die pad for mounting an electronic part; and a resin sealed mold 135 of the electronic part. The resin sealed lead frame has substantially the same shape and structure as those of the resin sealed lead frame shown in Figs. 13A and 13B.

Further, resin sealed lead frame 33 which has been subjected to the resin cut, dam bar cut and lead cut processes at lead processing basic unit 31 can be removed by one pitch through suitably provided removing mechanism (not shown).

It is noted that the work on the removed resin sealed lead frame 33 is generally cut and separated by the next step and, subsequently, a lead bending process for outer lead 132 is performed. As will later be described, the cutting and separating step for each work may be performed by a work cutting and separating portion on the resin sealed lead frame at removing portion 32 or between lead processing basic unit 31 and removing portion 32.

Further, a structure for automatically aligning the separated works and transporting them to the next step may be employed.

Now, referring to Fig. 5B, a structure to which another lead processing basic unit 310 having a function which is the same as that of lead processing basic unit 31 is added to a basic structure of the lead processing portion of the processing apparatus shown in Fig. 5A will be described.

The structure of the lead processing portion with lead processing basic unit 310 added includes: a feeding portion 30 for the resin sealed lead frame before lead process which is the same as the above described basic structure; a lead processing basic unit 31 for the resin sealed lead frame; and a removing portion 32 for the resin sealed lead frame after lead processing. Additional lead processing basic unit 310 having a function which is the same as that of lead processing basic unit 31 is detachably added between lead processing basic unit 31 and removing portion 32 through a suitably provided simple detachable means (not shown).

Similarly provided for additional lead processing basic unit 310 are: punch and die for resin cut A2 which is of the same type as that for lead processing basic unit 31; punch and die for dam bar cut 32; and punch and die for lead cut C2.

It is noted that in the above described structure, at least lead processing basic unit 31, additional lead processing basic unit 310 to be added and removing portion 32 need to be detachably connected through the suitably provided simple detaching means. However, each portion (that is, feeding portion 30, lead processing basic units 31, 310 and removing portion 32) is formed as a module, so that a structure with detachably connected modules may be employed.

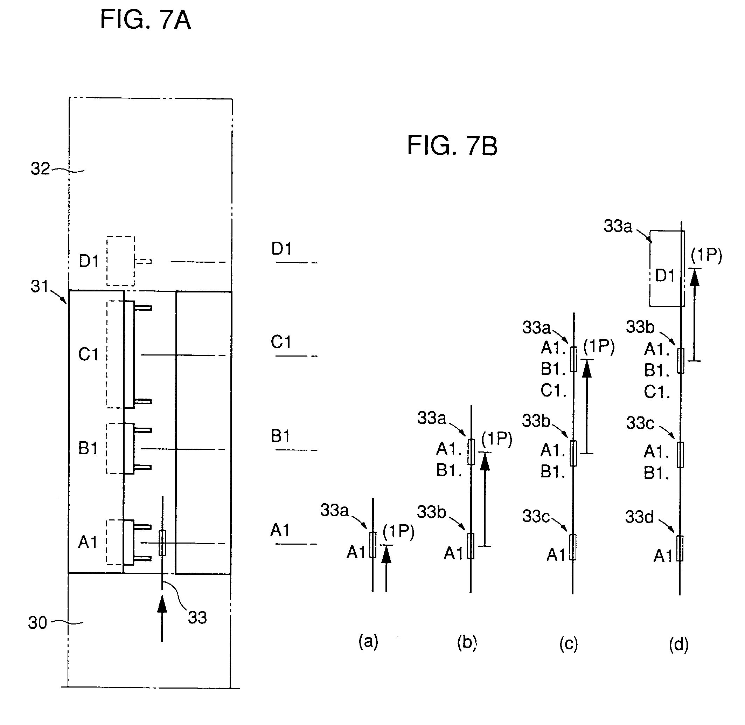

The steps and functions in the above described basic structure of the processing apparatus will be described with reference to Figs. 7A and 7B.

The basic structure has a structure similar to that of the conventional lead processing apparatus, so that the resin sealed lead frame may be sequentially fed by one pitch along the feeding path and pressed by molds for cutting which are spaced by one pitch. More specifically, as shown in Fig. 7B(a), resin sealed lead frame 33 is fed to lead processing basic unit 31 by one pitch (a first portion 13a) by a feeding mechanism at feeding portion 30 for a resin cut step (A1) for dam bar 131 by punch and die for resin cut A1.

Then, as shown in Fig. 7B(b), resin sealed lead frame 33 after resin cut step (A1) is further fed by one pitch (first portion 13a) and a dam bar cut step (B1) is provided for cutting dam bar 131 by punch and die for dam bar cut B1. At the time, first portion 13a is subjected to resin cut step (A1) and dam bar cut step (B1), and the following second portion 13b is subjected to a similar resin cut step (A1).

As shown in Fig. 7B(c), resin sealed lead frame 33 after resin cut step (A1) and dam bar cut step (B1) is further fed by one pitch (first portion 13a) and a lead cut step (C1) is performed for cutting a tip connecting portion of outer lead 132 by punch and die for lead cut C1. At the time, first portion 13a is subjected to resin cut step (A1), dam bar cut step (B1) and lead cut step (C1). The following second portion 13b is subjected to resin cut step (A1) and dam bar cut step (B1) and, the following third portion 13c is subjected to resin cut step (A1).

Then, as shown in Fig. 7B(d), resin sealed lead frame 33 after resin cut step (A1), dam bar cut step (B1) and lead cut step (C1) are further fed by one pitch (first portion 13a), so that it is removed from removing portion 32. At the time, second portion 13b is subjected to resin cut step (A1), dam bar cut step (B1) and lead cut step (C1) as in the above. The following third portion 13c is subjected to resin cut step (A1) and dam bar cut step (B1) and, the following fourth portion 13d is subjected to resin cut step (A1).

It is noted that cutting and separating step (D1) for each work can be successively performed by providing a work cutting and separating portion D1 on the above described resin sealed lead frame at removing portion 32 (or between lead processing basic unit 31 and removing portion 32) as indicated by a dotted line in Fig. 7A. In this case, cradle 133 which has been subjected to the above described steps needs only be removed.

Further, the works (see first portion 13a shown in Fig. 7B(d)) after work and cutting and separating step (D1) may be automatically aligned and transported to the next step.

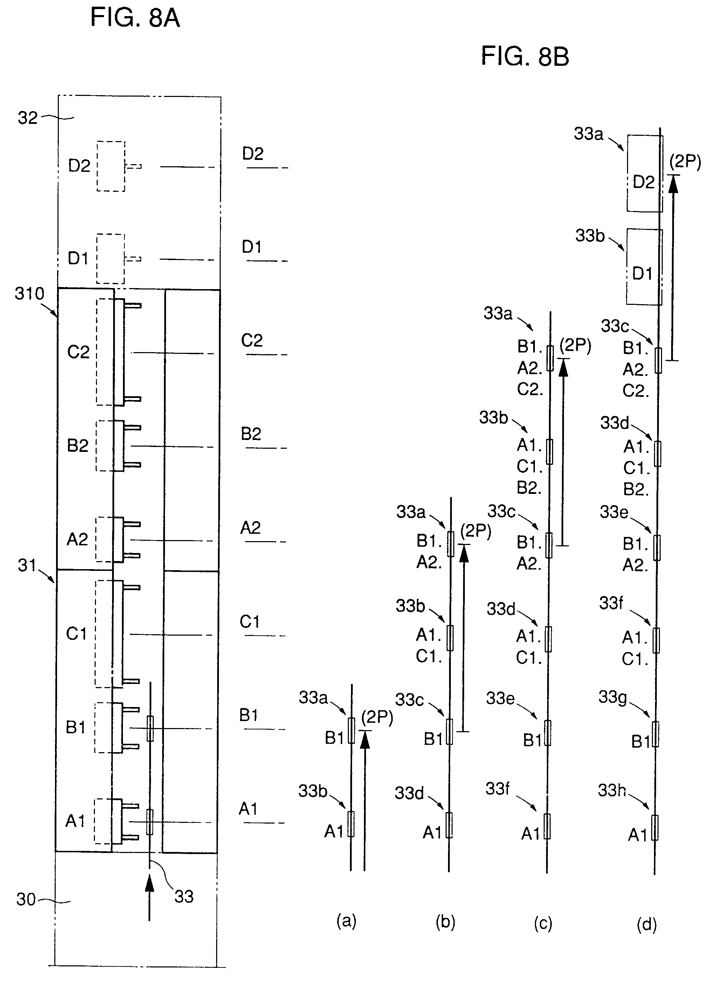

Now, the steps and functions for the structure to which another lead processing portion having a function substantially the same as that of the lead processing portion is added will be described with reference to Figs. 8A and 8B.

It is noted that the steps and functions for the structure are different from those of the above described basic structure in that lead processing basic unit 31 and removing portion 32 are detachably connected and another lead processing basic unit 310 provided with a function which is the same as that of lead processing basic unit 310 is detachably added between lead processing basic unit 31 and removing portion 32. Therefore, a lead processing apparatus having only one or at least two lead processing basic units can be arbitrarily selected and employed.

If the lead processing apparatus having two lead processing basic units 31 and 310 is selected and employed, resin sealed lead frame 33 is sequentially fed by two pitches to double the production volume.

When such structure is employed, as compared with the case where two lead processing apparatuses of the same kind having full functions are provided, overall reduction in equipment cost and the space for the lead processing apparatus can be achieved.

As shown in Fig. 8B(a), resin sealed lead frame 33 is fed by two pitches (first portion 13a and second portion 13b) by the feeding mechanism at feeding portion 30 to lead processing basic unit 31. First portion 13a is subjected to dam bar cut step (B1) for cutting dam bar 131 and second portion 13b is subjected to resin cut step (A1) for dam bar 131 by punch and the die for resin cut A1 and punch and the die for dam bar cut B1 of lead processing basic unit 31.

As shown in Fig. 8B(b), first and second portions 13a and 13b after the above described steps are further fed by two pitches. First portion 13a is subjected to resin cut step (A2) by punch and die for resin cut A2 of another lead processing basic unit 310, and second portion 13b is subjected to lead cut step (C1) by punch and die for lead cut C1 of lead processing basic unit 31. At the time, first portion 13a is subjected to dam bar cut step (B1) and resin cut step (A2), and second portion 13b is subjected to resin cut step (A1) and lead cut step (C1). Further, the following third portion 13c is subjected to dam bar cut step (B1), and still following fourth portion 13d is subjected to resin cut step (A1).

Then, as shown in Fig. 8B(c), first and second portions 13a and 13b after the above described steps are further fed by two pitches. First portion 13a is subjected to lead cut step (C2) by punch and die for lead cut C2 of lead processing basic unit 310, and second portion 13b is subjected to dam bar cut step (B2) by punch and die for dam bar cut B2 of lead processing basic unit 310.

At the time, first portion 13a is subjected to dam bar cut step (B1), resin cut step (A2) and the lead cut step (C2), and second portion 13b is subjected to resin cut step (A1), lead cut step (C1) and dam bar cut step (B2). The following third portion 13c is subjected to dam bar cut step (B1) and resin cut step (A2), and fourth portion 13d is subjected to resin cut step (A1) and lead cut step (C1). The still following fifth portion 13e is subjected to dam bar cut step (B1) and sixth portion 13f is subjected to resin cut step (A1).

As shown in Fig. 8B(d), first portion 13a after dam bar cut step (B1), resin cut step (A2) and the lead cut step (C2) and second portion 13b after resin cut step (A1), lead cut step (C1) and dam bar cut step (B2) are further fed by two pitches and removed from removing portion 32. Therefore, at the time, third portion 13c is subjected to dam bar cut step (B1), resin cut step (A2) and the lead cut step (C2), and fourth portion 13d is subjected to resin cut step (A1), lead cut step (C1) and dam bar cut step (B2). Fifth portion 13a is subjected to dam bar cut step (B1) and resin cut step (A2), and sixth portion 13f is subjected to dam bar cut step (B1) and resin cut step (A2), and sixth portion 13f is subjected to resin cut step (A1) and lead cut step (C1). Further, the following seventh portion 13g is subjected to dam bar cut step (B1) and eighth portion 13h is subjected to resin cut step (A1).

It is noted that two work cutting and separating portions (D1, D2) corresponding to two pitches of transportation are provided at removing portion 32 (or between lead processing basic unit 310 and removing portion 32) as indicated by a dotted line in Fig. 8A, so that cutting and separating step (D1, D2) can be performed sequentially after the above described steps. In this case, only cradle 133 which has been subjected to the above described steps needs only be removed.

The works (see first and second portions 13a and 13b shown in Fig. 8B(d)) after lead cutting and separating step (D1, D2) may be automatically aligned and transported to the next step.

As described above, in the structure in which additional lead processing basic unit 310 having a function which is the same as that of lead processing basic unit 31 is added to the basic structure of the aforementioned processing apparatus, at least lead processing basic unit 31 and removing portion 32 are detachably connected and additional lead processing basic unit 310 is detachably added to lead processing basic unit 31. Therefore, the lead processing apparatus may be structured to have only one lead processing basic unit as shown in Fig. 5A, or two lead processing basic units 31, 110 as shown in Fig. 5B.

In addition, at least lead processing basic unit 31 and additional lead processing basic unit 310 or removing portion 32 is detachably connected in a module, the number of the lead processing portions can suitably be changed as necessary.

When the lead processing apparatus provided with two lead processing basic units 31 and 310 is selected and employed, the production volume increases twice. Moreover, in the structure, as feeding portion 30 of the resin sealed lead frame before lead processing and removing portion 32 of the resin sealed lead frame after lead processing may be the same. Therefore, as compared with the case where two lead processing apparatuses of the same kind having full functions are provided, overall reduction in equipment cost and space for the lead processing apparatus can be advantageously achieved.

The present invention is not limited to the above described embodiments, and various modifications can be made without departing from the scope of the invention.

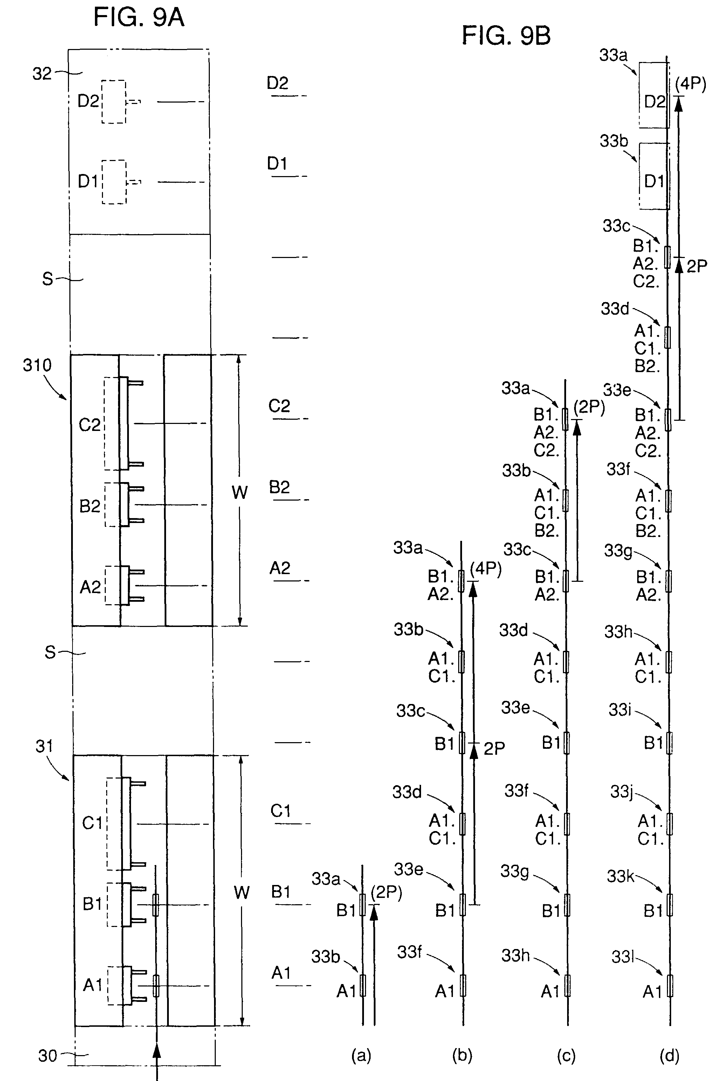

For example, lead processing may be performed for the resin sealed lead frame having different pitches. Moreover, as shown in Fig. 9A, lead processing may be performed for the resin sealed lead frame having different pitches because of the shape, width W or the like of the above mentioned lead processing portion.

In this case, however, the following adjustment of the pitches enables the above described lead processing.

More specifically, a required space S (corresponding to two pitches) may be provided between two lead processing basic unit 31 and 310 as well as between lead processing basic unit 310 and removing portion 32.

In the provided space S, the lead processing step is not performed. Thus, to perform processing by another lead processing basic unit 310 after processing by lead processing basic unit 31, the resin sealed lead frame may be fed by four pitches (see first portion 13a shown in Figs. 9B(b) and (d)). Further, to feed from additional lead processing basic unit 310 to removing portion 32 or from additional lead processing basic unit 310 to work cutting and separating portion (D1, D2), the resin sealed lead frame may be similarly fed by four pitches.

Despite the above mentioned functional difference, the structure shown in Fig. 9A is similar to those of the first and second embodiments in the feeding step for sequentially feeding the resin sealed lead frame by two pitches, in the lead processing step for performing a prescribed lead processing for the portions spaced by two pitches, and in the removing step. Therefore, the structure shown in Fig. 9A, can provide substantially the same effect as that of the above described embodiments.

In the embodiment shown in Fig. 9A, the feeding step for sequentially feeding the resin sealed lead frame by two pitches, the lead processing step for performing a prescribed lead processing for portions spaced by two pitches and the removing step are performed. The number of pitches by which the resin sealed lead frame is fed may be at least two.

More specifically, a functional effect similar to that described above can be obtained by the feeding step for sequentially feeding the resin sealed lead frame by two pitches, the lead processing step for performing a prescribed lead processing for portions of the resin sealed lead frame fed by the feeding step which are spaced by at least two pitches and the removing step for removing the resin sealed lead frame which has been subjected to the lead processing step.

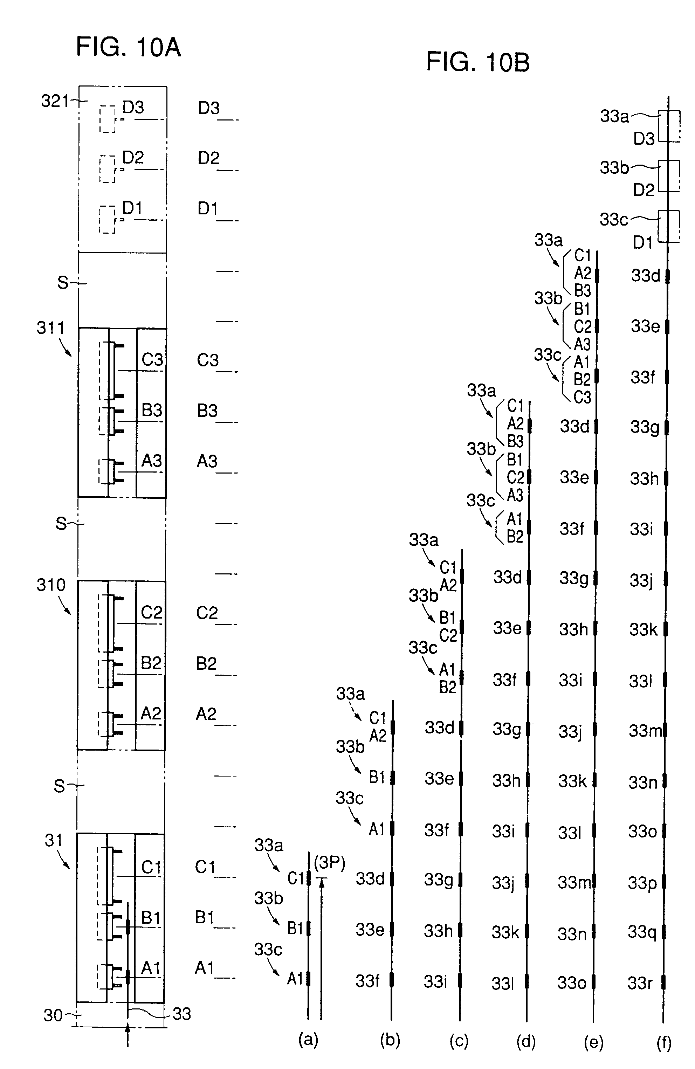

Now, referring to Figs. 10A and 10B, the resin sealed lead frame will be described as being sequentially fed by three pitches.

Fig. 10A shows a structure in which three lead processing basic units 31, 310 and 311 are provided along a feeding path of the resin sealed lead frame, a space S corresponding to a required pitch is provided between lead processing basic unit 311 and removing portion 321, and removing portion 321 includes three work cutting and separating portions (D1, D2, D3).

As shown in Figs. 10B(a) to (f), despite the functional difference in the feeding step for sequentially feeding the resin sealed lead frame by three pitches, the lead processing step for performing a prescribed lead processing for portions spaced by three pitches, the work cutting and separating step and the removing step for removing the resin sealed lead frame, substantially the same function and effect can be obtained by sequentially feeding the resin sealed lead frame by a plurality of pitches for performing a prescribed lead processing for the portions spaced by the plurality of pitches.

In each of the embodiments shown in Figs. 9A and 10A, a mechanism for inspecting the state of lead processing or the like can suitably be arranged at the portions spaced by the pitches, while making use of space S.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A method of processing a resin sealed lead frame, comprising the steps of:
providing separate processing means (101, 102, 103, 104) corresponding to a plurality of steps to be used for processing a lead of resin sealed lead frame (A) as modules and detachably connecting said processing means; and
selecting and connecting said processing means as said modules related to said steps actually required for processing the lead of said resin sealed lead frame to be performed and sequentially feeding said resin sealed lead frame to said processing means as said modules for processing the lead of said resin sealed lead frame.

2. The method of processing the resin sealed lead frame according to claim 1, wherein said processing means (101, 102, 103, 104) as said modules include a cavity flow cut module (101), a resin cut module (102), a dam bar cut module (103) and a pinch lead cut module (104).

3. The method of processing the resin sealed lead frame according to claim 1, further comprising a receiving step for receiving each work separated from said resin sealed lead frame (A) after said lead processing.

4. The method of processing the resin sealed lead frame according to claim 1, wherein said resin sealed lead frame is transported by at least two pitches when a pitch between works on said resin sealed lead frame corresponds to one pitch in said lead processing.

5. A processing apparatus for a resin sealed lead frame, characterized in that processing means (101, 102, 103, 104) related to a plurality of steps to be used for processing a lead of a resin sealed lead frame (A) are separated as modules and detachably connected.

6. The processing apparatus for the resin sealed lead frame according to claim 5, wherein said processing means as said modules include a cavity flow cut module (101), a resin cut module (102), dam bar cut module (103) and a pinch lead cut module (104).

7. The processing apparatus for the resin sealed lead frame according to claim 5, further comprising receiving means for receiving each work separated from said resin sealed lead frame (A) after said lead processing.

8. A method of processing a resin sealed lead frame having a plurality of works spaced by a prescribed distance using a processing apparatus for a resin sealed lead frame including:
a feeding portion (30) for the resin sealed lead frame before lead processing arranged along a feeding path of said resin sealed lead frame (33);
a lead processing portion (31, 310) for the resin sealed lead frame connected to said feeding portion; and
a removing portion (32) for the resin sealed lead frame after the lead processing detachably connected to said lead processing portion;
said method comprising the steps of:
sequentially feeding said resin sealed lead frame by at least two pitches when a pitch between said works corresponds to one pitch in said resin sealed lead frame with a plurality of lead processing basic units (31, 310) having same lead processing function and detachably connected in series in said lead processing portion;
performing a prescribed lead processing by said plurality of lead processing basic units in said lead processing portion for said works at positions spaced by said plurality of pitches of said resin sealed lead frame from said feeding step; and
removing said resin sealed lead frame after said lead processing step at said removing portion.

9. The step of processing the resin sealed lead frame according to claim 8, further comprising the step of cutting and separating said work on said resin sealed lead frame before said removing step for said resin sealed lead frame (33).

10. The method of processing the resin sealed lead frame according to claim 8, wherein a region (S) not performing said lead processing is provided between said mutually adjacent lead processing basic units (31, 310) and between said lead processing portion and said removing portion (32) and said regions (S) are spaced by a plurality of pitches.

11. The method of processing the resin sealed lead frame according to claim 8, wherein the resin cut step (A1, A2), the dam bar cut step (B1, B2) and the lead cut step (C1, C2) are performed for each of said plurality of lead processing basic units (31, 310).

12. A processing apparatus for a resin sealed lead frame, comprising:
a feeding portion (30) for a resin sealed lead frame before lead processing arranged along a feeding path of said resin sealed lead frame (33);
a lead processing portion (31, 310) for said resin sealed lead frame detachably connected to said feeding portion; and
a removing portion (32) for said resin sealed lead frame after said lead processing detachably connected to said lead processing portion,
said lead processing portion including a plurality of lead processing basic units (31, 310) having same lead processing function and detachably connected in series.

13. The processing apparatus for the resin sealed lead frame according to claim 12, wherein a work cutting and separating portion is provided in said removing portion (32).

14. The processing apparatus for the resin sealed lead frame according to claim 12, wherein a region (S) not performing said lead processing is provided between said mutually adjacent lead processing basic units (31, 310) and between said lead processing portion and said removing portion (32) and said regions (S) are spaced by a plurality of pitches when a pitch between said works on said resin sealed lead frame corresponds to one pitch.

15. The method of processing the resin sealed lead frame according to claim 12, further comprising resin cut means (A1, A2), dam bar cut means (B1, B2) and lead cut means (C1, C2).
